(19) Europäisches Patentamt
European Patent Office
Office européen des brevets

(11) Publication number: **0 407 130 A1**

# EUROPEAN PATENT APPLICATION

(21) Application number: 90307227.0

(22) Date of filing: 02.07.90

(51) Int. Cl.⁵: **H01L 21/265**, H01L 29/10, H01L 29/36

(30) Priority: 03.07.89 US 375176

(43) Date of publication of application:
09.01.91 Bulletin 91/02

(84) Designated Contracting States:
DE FR GB IT

(71) Applicant: MOTOROLA, INC.
1303 East Algonquin Road
Schaumburg, IL 60196(US)

(72) Inventor: Nair, Vijay K.
2646 E Fountain Street
Mesa, Arizona 85213(US)
Inventor: Wu, Schyi-Yi
1340 E Medina
Mesa, Arizona 85202(US)
Inventor: Mellen, Neal
633 W Southern No. 1135
Tempe, Arizona 85282(US)

(74) Representative: Dunlop, Hugh Christopher et al
Motorola European Intellectual Property
Operations Jays Close Viables Industrial
Estate
Basingstoke, Hampshire RG22 4PD(GB)

(54) A low noise and high gain mesfet having improved performance at low current levels.

(57) A low noise and high gain MESFET at low current levels is fabricated by using a semi-insulating gallium arsenide substrate having a high resistivity and ion implanting the channel region. The high resistivity substrate and suitable implant conditions form an improved profile in the channel region which leads to higher transconductance to gate capacitance ratio at a low operating current.

# A LOW NOISE AND HIGH GAIN MESFET HAVING IMPROVED PERFORMANCE AT LOW CURRENT LEVELS

## Background of the Invention

This invention relates, in general, to gallium arsenide MESFETs, and more particularly, to a method of fabricating a low noise and high gain MESFET having improved performance at low current levels.

The trend in the gallium arsenide industry has been to use semi-insulating substrates with resistivities in the range of 1 to 5 X $10^7$ ohm-cm to fabricate MESFETs. Ion implantation of dopants to form a channel region is typically performed through silicon nitride (approximately 700 angstroms) with an ion implant energy in the range of 140 to 200 KeV. This combination of ion implant energy and substrate resistivity has resulted in good noise figures and associated gain at about 10 mA of device current (which has been traditionally used in the industry as the current level for benchmarking MESFET devices). However, when these devices are operated at very low currents (0.5 mA), the noise figure increases and the gain decreases. This trend has been observed for MESFETs fabricated by using ion implantation or by using an epitaxial structure.

In the past, a high current MESFET, typically an epitaxially grown MESFET, was just biased down to low current levels. When this is done, however, unacceptable values and variation in the device noise figure and gain can occur making amplifier performance unpredictable. Another method commonly used is to design a multi-stage amplifier to meet the gain and noise specification for the system. This solution, however, is also unacceptable because it leads to a larger current draw and, hence, higher power requirements.

It is generally known in the art that increasing transconductance and reducing gate to source capacitance for fixed source and gate resistances are essential for improving the associated gain and lowering the noise figure of gallium arsenide MESFETs. A reduction in gate to source capacitance and an increase in transconductance has been obtained by reducing the gate length of the device and changing the doping concentration in the channel region or by providing a graded channel doping profile. These techniques have been sufficient for devices which operate at high currents, 10 mA or above. However, when these devices are operated at very low currents, the noise figure and gain are still unacceptable due to a very low transconductance to gate capacitance ratio in this operating region. Some improvement can be obtained by fabricating the FET on a heterostructure epitaxial material, however, this is still not sufficient for low current operation, and much more expensive than fabricating an ion implanted MESFET.

By now, it should be appreciated that it would be advantageous to provide a MESFET having low noise and high gain at low currents.

Accordingly, it is an object of the present invention to provide a low noise and high gain MESFET for low current operation.

Another object of the present invention is to provide an improved MESFET for low current operation that can be fabricated at low cost and high volume without resorting to more expensive heterostructure epitaxial material.

A further object of the present invention is to provide a ion implanted MESFET having an improved noise figure at low current.

An additional object of the present invention is to provide an improved MESFET having a high transconductance-to- gate capacitance ratio at low currents.

## Summary of the Invention

In accordance with the present invention, the above and other objects and advantages are achieved by providing a MESFET fabricated on a high resistivity substrate and by using predetermined implant conditions to form the channel region having a sharp dopant profile. The improved dopant profile leads to a higher transconductance to gate capacitance ratio at low current operation, which in turn improves the noise figure and gain. Further improvement is also possible by using techniques such as rapid thermal anneal to reduce or eliminate implant defects.

## Brief Description of Drawings

FIGS. 1-2 illustrate enlarged, cross-sectional views of a portion of a MESFET at different stages of fabrication;

FIG. 3 is a graph of substrate resistivity versus noise figure two ion implant conditions used to form the channel region of a MESFET; and

FIG. 4 is a graph of substrate resistivity versus associated gain for two ion implant conditions used to form a channel region of a MESFET.

## Detailed Description of Drawings

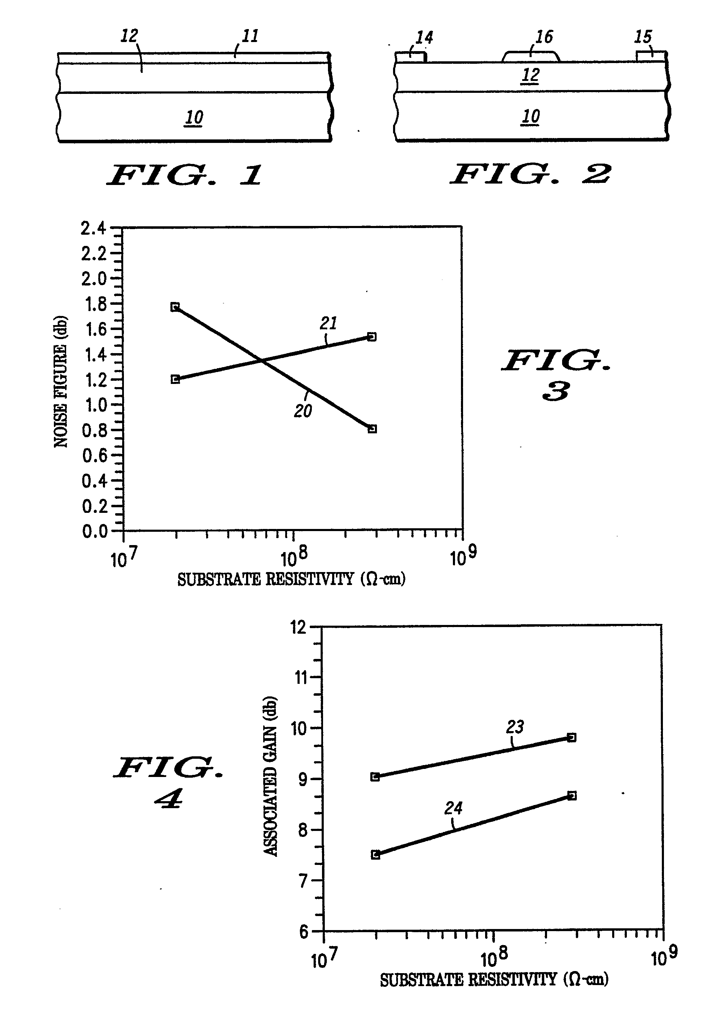

FIG. 1 illustrates an enlarged cross-sectional view of a MESFET fabricated in accordance with the present invention. A semi-insulating gallium arsenide substrate 10 is provided to begin the fabrication. The present invention uses semi-insulating substrate 10 having a high resistivity approximately greater than $5 \times 10^7$ ohm-cm. For purposes of this invention, the division between low and high resistivity substrates is defined at approximately $5 \times 10^7$ ohm-cm. A high resistivity substrate 10 can be grown by doping the gallium arsenide with dopants such as chromium and/or carbon. In a preferred embodiment, the resistivity of semi-insulating substrate 10 is approximately in the range of $10^8$ ohm-cm. Subsequently, an insulating layer is formed on the top surface of substrate 10. In the present invention, the insulating layer is a silicon nitride layer 11 which is sputtered on the surface of substrate 10 to a thickness of approximately 500 to 1000 angstroms. However, other suitable deposition processes may be used. Silicon nitride layer 11 is used as a cap for ion implantation, but ion implantation can also be done without silicon nitride layer 11. In addition, other materials, such as silicon dioxide or an oxynitride can be used in place of silicon nitride layer 11. Next, silicon, or another suitable N-type dopant, is implanted into substrate 10 through silicon nitride layer 11 to form a channel region 12 having a sharp dopant profile. For example, if a silicon nitride layer 11, having a thickness of approximately 750 angstroms is used, then a silicon dose of approximately $6 \times 10^{12}$ atoms/cm² at an ion implant energy in the range of 100 to 140 KeV is preferably used. If a silicon nitride layer 11 is of a different thickness or no silicon nitride layer 11 is used, or a different dose of silicon is used, it is well known in the art that the ion implantation energy must be changed accordingly. Equivalent ion implantation parameters, energy and dose, must be used in order to obtain a MESFET having a desired pinch-off voltage. A pinch-off voltage in the range of -2.0 to 0 volts is desirable for some applications. The ion implantation energy and dose will differ for a different thickness or composition of layer 11. A higher acceptor impurity concentration in high resistivity substrate 10 and appropriate ion implant conditions sharpen the dopant profile of channel region 12, which will lead to a higher transconductance-to-gate capacitance ratio at low currents, and thus provide for a MESFET having low noise and high gain. A MESFET fabricated in accordance with the present invention also exhibits good performance at higher currents. A further reduction in the noise figure and an increase in associated gain is possible by further adjustment of the implant conditions and increasing the resistivity of substrate 10 to improve or sharpen the dopant profile of channel region 12. Magnesium, or other suitable P-type dopants, may also be implanted into substrate 10 to further improve the profile of channel region 12.

FIG. 2 illustrates an enlarged, cross-sectional view of a MESFET device further along in the process. After ion implantation of channel region 12, more silicon nitride is sputtered on silicon nitride layer 11 in order to ensure that there are no pinholes in silicon nitride layer 11. Also, a silicon nitride layer (not shown) of a thickness equal to the total thickness of silicon nitride layer 11 is then sputtered on to the bottom surface of substrate 10 to prevent decomposition of gallium arsenide substrate 10 and to balance the stress of silicon nitride layer 11. Substrate 10 is then annealed to activate the ion implanted dopants in channel region 12 and to anneal out defects. A suitable process for anneal is carried out at a temperature of 850°C for approximately 20 minutes. A rapid thermal anneal process may be used to obtain better annealing, which may result in a lower noise figure and higher gain. Other suitable anneal processes may also be used, some of which may eliminate the need for silicon nitride layer 11. Silicon nitride layer 11 is removed, along with the silicon nitride layer deposited on the back of substrate 10. Standard processes well known in the art are then used to form ohmic source, drain and Schottky gate electrodes 14, 15 and 16, respectively.

FIG. 3 is a graph of substrate resistivity versus noise figure of a MESFET for two combinations of implant energy and dose of channel region 12 dopants. Shown on the abscissa is the substrate resistivity in ohm-cm and on the ordinate is the noise figure in dB. Line 20 shows the corresponding noise figure of a MESFET fabricated, in accordance with the present invention, using an ion implant energy of approximately 110 KeV, a silicon dose of approximately $6 \times 10^{12}$ atoms/cm², and a silicon nitride layer 11 having a thickness of approximately 750 angstroms. Line 21 shows the noise figure of a MESFET fabricated using an ion implant energy of approximately 170 KeV, a silicon dose of $2.3 \times 10^{12}$, and a 750 angstrom silicon nitride layer 11. The implant conditions represented by line 20 and line 21 will be referenced as implant condition 1 and 2, respectively.

FIG. 4 is a graph of substrate resistivity versus associated gain of a MESFET for the two combinations of ion implantation dose and energy of channel region 12 dopants. Shown on the abscissa is the substrate resistivity in ohm-cm and on the ordinate in dB is the associated gain. Line 23 is the associated gain of a MESFET fabricated using implant condition 1, and line 24 is the associated gain of a MESFET fabricated using implant condition 2. All data shown in FIGS. 3 and 4 were taken using a Vds of 3 volts, an Ids of 0.5 mA and a frequency of 1 GHz. Note that if condition 1 is used, increasing the substrate resistivity decreases the noise figure (line 20) and increases the associated gain (line 23). However, if condition 2 is used, increasing the substrate resistivity increases the associated gain (line 24), but also increases the noise figure (lines 21). Condition 1 also provides a higher associated gain than condition 2. Although not illustrated in FIG. 3, a further adjustment of implant condition 1 and a higher substrate resistivity will provide for a lower noise figure and higher gain. Ion implant condition 1, an example of one embodiment of the present invention, provides for an improved, sharpened dopant profile. The conditions of ion implant condition 2 were chosen in order to obtain a pinch-off voltage approximately equal to that of a MESFET fabricated using ion implant condition 1. Ion implant condition 2 does not provide for an improved, sharpened dopant profile.

By now it should be appreciated that there has been provided a MESFET having low noise and high gain at low currents. The MESFET of the present invention can be made without resorting to more expensive heterostructure epitaxial material. The ion implanted MESFET of the present invention can be fabricated at a low cost and high volume with good reproducibility and uniformity.

## Claims

1. A method of making a low noise and high gain MESFET having improved performance at low current levels, comprising the steps of:
providing a semi-insulating gallium arsenide substrate (10) having a high resistivity; and
ion implanting a predetermined dose of an N-type dopant into the substrate at a predetermined ion implant energy to form a channel region (12) having a sharp dopant profile.

2. The method of claim 1 wherein the substrate (10) is doped with carbon.

3. The method of claim 1 wherein the substrate (10) is doped with chromium.

4. The method of claim 1 wherein the ion implant energy is approximately 110 to 140 KeV, the N-type dopant is silicon and the dose is approximately $6 \times 10^{12}$ atoms/cm$^2$.

5. The method of claim 1 further comprising the step of: ion implanting a a P-type dopant into the substrate (10) to improve the dopant profile.

6. The method of claim 1 further comprising the step of: forming an ion implantation cap (11) on the substrate (10) before the step of ion implanting the channel region (12).

7. The method of claim 1 further comprising the step of: annealing the substrate (10) after ion implanting to activate the dopant and remove defects.

8. The method of claim 7 wherein the annealing is done at a temperature of approximately 850°C for approximately 30 minutes.

9. The method of claim 7 wherein the annealing entails a rapid thermal anneal.

10. A MESFET comprising:
a gallium arsenide substrate (10) having a high resistivity; and an N-type dopant in the substrate forming a channel region (12) having a sharp dopant profile.

FIG. 1

FIG. 2

FIG. 3

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 112 657 (FUJITSU) * Page 5, line 32 - page 9, line 23 * | 1,3,6-8 ,10 | H 01 L 21/265 H 01 L 29/10 H 01 L 29/36 |
| A | --- | 4 | |
| X | EP-A-0 034 729 (SIEMENS) * Page 4, line 30 - page 5, line 3; claims 1-3,6 * | 1,6,7, 10 | |
| A | --- | 4 | |
| X | ELECTRONICS LETTERS, vol. 20, nos. 25/26, December 1984, pages 1029-1031, Stevenage, Herts, GB; K. YAMASAKI et al.: "Below 10 ps/gate operation with buried p-layer saint FETs" * Whole document * | 1,5-7, 10 | |
| A | IDEM --- | 4,8 | |
| X | REVIEW OF THE ELECTRICAL COMMUNICATIONS LABORATORIES, vol. 36, no. 6, November 1988, pages 531-537, Nippon Telegraph and Telephone Corp., Tokyo, JP; H. YAMAZAKI et al.: "Ion implantation for GaAs LSI fabrication" * Pages 531,533 * | 1,5,7, 10 | TECHNICAL FIELDS SEARCHED (Int. Cl.5) H 01 L |
| X | US-A-4 391 651 (THE USA AS REPRESENTED BY THE SECRETARY OF THE NAVY) * Page 1, line 48 - page 4, line 10 * --- -/- | 1,7,10 | |

The present search report has been drawn up for all claims

| Place of search | Date of completion of the search | Examiner |
|---|---|---|
| THE HAGUE | 07-09-1990 | GELEBART J.F.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

European Patent Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | JOURNAL OF THE ELECTROCHEMICAL SOCIETY, vol. 123, no. 10, October 1976, pages 1588-1589; B.K. SHIN et al.: "An abrupt dopant profile in GaAs produced by Te implantation" * Whole document * | 1,3,10 | |
| A | JOURNAL OF THE ELECTROCHEMICAL SOCIETY, vol. 133, no. 12, December 1986, pages 2590-2596, Manchester, New-Hampshire, US; S.S. GILL et al.: "Review of rapid thermal annealing of ion implanted GaAs" * Page 2591 * | 7-9 | |
| A | SUMITOMO ELECTRIC TECHNICAL REVIEW, no. 28, January 1989, pages 211-216; M. KIYAMA et al.: "Effects of substrate on electrical activation of Si-implanted GaAs" | 1,2,4,7,8 | |

TECHNICAL FIELDS SEARCHED (Int. Cl.5)

The present search report has been drawn up for all claims

| Place of search | Date of completion of the search | Examiner |
|---|---|---|
| THE HAGUE | 07-09-1990 | GELEBART J.F.M. |